# EUROPEAN PATENT APPLICATION

(11) **EP 4 726 423 A1**
(43) Date of publication of application: **15.04.2026**
(21) Application number: 25745388.6
(22) Date of filing: 24.01.2025
(51) Int. Cl.: G01R 31/396, G01R 35/00, G01R 31/382, B60L 58/10

(54) **APPARATUS AND METHOD FOR GENERATING BATTERY INFORMATION**

(30) Priority: 26.01.2024 KR 20240012347
(71) Applicant: LG Energy Solution, Ltd., Seoul 07335 (KR)
(72) Inventor: CHOI, Soon-Hyung, Daejeon 34122 (KR)
(74) Representative: Goddar, Heinz J.
(86) International application number: PCT/KR2025/001463
(87) International publication number: WO 2025/159566

(57) **Abstract**

The battery information generating apparatus according to an embodiment of the present disclosure includes a profile obtaining unit configured to obtain a battery profile based on a voltage and a capacity of a battery; and a control unit configured to determine a target C-rate corresponding to the battery profile and generate a corrected profile by correcting the battery profile based on an overpotential profile corresponding to the target C-rate.

## Description

### TECHNICAL FIELD

This application is based on and claims priority from Korean Patent Application No. 10-2024-0012347, filed on January 26, 2024, with the Korean Intellectual Property Office, the disclosure of which is incorporated herein in its entirety by reference.

The present disclosure relates to a battery information generating apparatus and method, and more particularly, to a battery information generating apparatus and method for efficiently generating information related to a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

In the past, the state of a battery was diagnosed by analyzing a battery profile that represents the corresponding relationship between the voltage and capacity of the battery. For example, the capacity and voltage were measured during the charging process of the battery, and the state of the battery was diagnosed by analyzing a battery profile that represents the corresponding relationship between the measured voltage and capacity. As another example, the state of the battery can be diagnosed based on the capacity and voltage measured during the discharging process of the battery.

Here, in order to diagnose the current state of the battery more accurately, a battery profile that accurately reflects the current state of the battery is required. However, there is a problem in that a low-rate charge/discharge such as 0.05 C (C-rate) is required to obtain such a profile. That is, since a low-rate charge/discharge was required in the past to diagnose the state of the battery, there were limitations in diagnosing the state of the battery.

For example, when charging and discharging a battery at 0.33 C or higher, since the acquired profile includes overpotential, the profile may not accurately reflect the current state of the battery due to the effect of overpotential. Since there is concern that the state of the battery may not be accurately diagnosed when using a profile that includes overpotential, low-rate charging and discharging is required to accurately diagnose the battery state.

### DISCLOSURE

### Technical Problem

The present disclosure is designed to solve the problems of the related art, and therefore the present disclosure is directed to providing a battery information generating apparatus and method that quickly generates a profile used for battery state diagnosis.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery information generating apparatus according to one aspect of the present disclosure may comprise a profile obtaining unit configured to obtain a battery profile based on a voltage and a capacity of a battery; and a control unit configured to determine a target C-rate corresponding to the battery profile and generate a corrected profile by correcting the battery profile based on an overpotential profile corresponding to the target C-rate.

The control unit may be configured to generate the corrected profile by calculating a difference between the battery profile and the overpotential profile.

The overpotential profile may be configured to be pre-stored for each of a plurality of C-rates.

The control unit may be configured to select an overpotential profile corresponding to the target C-rate from among a plurality of overpotential profiles pre-stored.

The overpotential profile may be preset based on a reference battery profile of a reference battery for a reference C-rate and a target battery profile of the reference battery for the target C-rate.

The overpotential profile may be preset to represent a difference between the reference battery profile and the target battery profile.

The target C-rate may be set to be greater than the reference C-rate.

The control unit may be configured to provide information about the battery by outputting the corrected profile to the outside.

A battery pack according to another aspect of the present disclosure may comprise the battery information generating apparatus according to one aspect of the present disclosure.

A vehicle according to still another aspect of the present disclosure may comprise the battery information generating apparatus according to one aspect of the present disclosure.

A battery information generating method according to still another aspect of the present disclosure may comprise a profile obtaining step of obtaining a battery profile based on a voltage and a capacity of a battery; a target determining step of determining a target C-rate corresponding to the battery profile; and a corrected profile generating step of generating a corrected profile by correcting the battery profile based on an overpotential profile corresponding to the target C-rate.

### Advantageous Effects

According to one aspect of the present disclosure, the battery information generating apparatus may drastically reduce the total time required to diagnose the state of a battery by quickly generating a corrected profile used to diagnose the state of a battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a schematic drawing of a battery information generating apparatus according to an embodiment of the present disclosure.
FIG. 2 is a schematic drawing of a first example of a battery profile according to an embodiment of the present disclosure.
FIG. 3 is a schematic drawing of a second example of the battery profile according to an embodiment of the present disclosure.
FIG. 4 is a schematic drawing of a third example of the battery profile according to an embodiment of the present disclosure.
FIG. 5 is a schematic drawing of an overpotential profile according to an embodiment of the present disclosure.
FIG. 6 and FIG. 7 are schematic drawings of a corrected profile according to an embodiment of the present disclosure.
FIG. 8 is a drawing schematically showing a battery pack according to another embodiment of the present disclosure.
FIG. 9 is a drawing schematically showing a vehicle according to still another embodiment of the present disclosure.
FIG. 10 is a diagram schematically showing a battery information generating method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

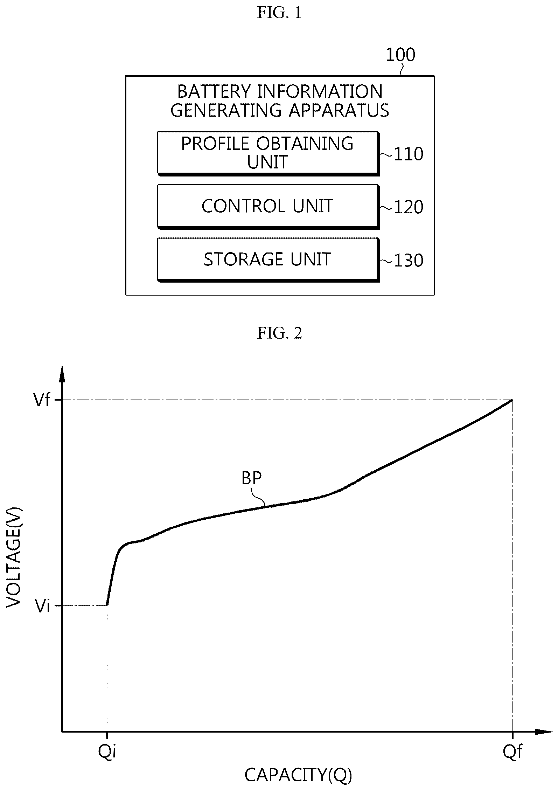

FIG. 1 is a diagram schematically illustrating a battery information generating apparatus 100 according to an embodiment of the present disclosure.

Referring to FIG. 1, the apparatus 100 for diagnosing a battery may include a profile obtaining unit 110, a control unit 120, and a storage unit 130.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a battery profile based on the voltage and capacity of the battery.

Specifically, the battery profile may include at least one of a full-cell profile representing a corresponding relationship between the voltage and capacity of the battery, a first differential profile representing a corresponding relationship between the capacity of the battery and a differential voltage, and a second differential profile representing a corresponding relationship between the voltage and a differential capacity of the battery.

FIG. 2 is a schematic drawing of a first example of a battery profile according to an embodiment of the present disclosure. Specifically, FIG. 2 is a schematic drawing of a full-cell profile BP of the battery. The full-cell profile BP may be expressed as an X-Y graph where the X-axis is set to capacity (Q) and the Y-axis is set to voltage (V).

The full-cell profile BP is a profile representing the corresponding relationship between voltage V and capacity Q when the SOC of the battery is charged from a preset charge start SOC, or 0%, to a preset charge end SOC, or 100%. As another example, the full-cell profile BP may represent the corresponding relationship between voltage V and capacity Q when the state of charge of the battery is discharged from the preset discharge start SOC, or 100%, to the preset discharge end SOC, or 0%.

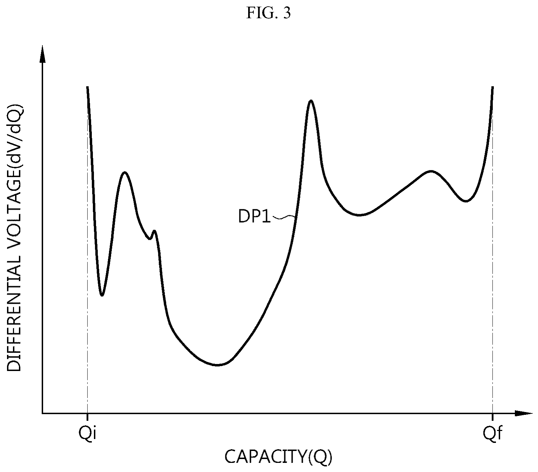

FIG. 3 is a schematic drawing of a second example of the battery profile according to an embodiment of the present disclosure. Specifically, FIG. 3 is a schematic drawing of a first differential profile DP1 of the battery. The first differential profile DP1 may be represented as an X-Y graph where the X-axis is set to capacity (Q) and the Y-axis is set to differential voltage (dV/dQ).

When the full-cell profile BP is differentiated with respect to the capacity, a first differential profile DP1 may be generated that represents the corresponding relationship between the differential voltage (dV/dQ) and the capacity (Q). Here, the differential voltage is the derivative of the voltage with respect to the capacity, which is the value obtained by differentiating the voltage with respect to the capacity.

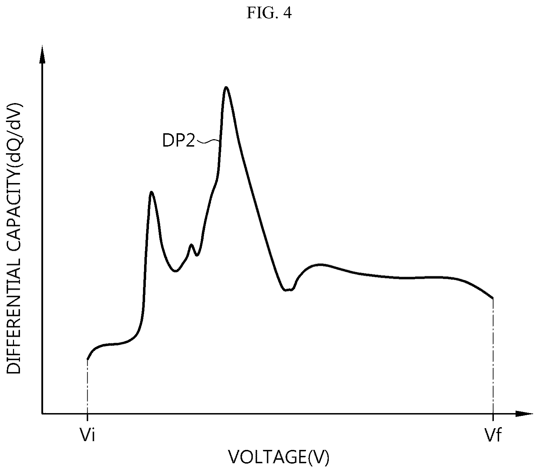

FIG. 4 is a schematic drawing of a third example of the battery profile according to an embodiment of the present disclosure. Specifically, FIG. 4 is a schematic drawing of a second differential profile DP2 of the battery. The second differential profile DP2 may be represented as an X-Y graph where the X-axis is set to voltage (V) and the Y-axis is set to differential capacity (dQ/dV).

When the full-cell profile BP is differentiated with respect to voltage, a second differential profile DP2 representing the corresponding relationship between the differential capacity (dQ/dV) and the voltage (V) may be generated. Here, the differential capacity is the derivative of the capacity with respect to voltage, which is the value obtained by differentiating the capacity with respect to voltage.

For example, the profile obtaining unit 110 may directly receive the battery profile from the outside. That is, the profile obtaining unit 110 may obtain the battery profile by receiving the battery profile from the outside that is connected to enable communication in a wired and/or wireless manner.

As another example, the profile obtaining unit 110 may directly receive the full-cell profile BP of the battery from the outside. Then, the profile obtaining unit 110 may generate a differential profile DP1, DP2 based on the full-cell profile BP. That is, the profile obtaining unit 110 may obtain the differential profile DP1, DP2 by receiving the full-cell profile BP from the outside that is connected to enable communication in a wired and/or wireless manner, and directly generating the differential profile DP1, DP2 from the full-cell profile BP.

As another example, the profile obtaining unit 110 may receive battery information about the voltage and capacity of the battery. Then, the profile obtaining unit 110 may generate a full-cell profile BP based on the received battery information, and generate a differential profile DP1, DP2 based on the generated full-cell profile BP. That is, the profile obtaining unit 110 may obtain a battery profile by directly generating the full-cell profile BP and the differential profile DP1, DP2 based on the battery information.

The profile obtaining unit 110 may be connected to communicate with the control unit 120. For example, the profile obtaining unit 110 may be connected to the control unit 120 by wire and/or wirelessly. The profile obtaining unit 110 may transmit the obtained battery profile to the control unit 120.

The control unit 120 may be configured to determine a target C-rate corresponding to the battery profile.

Specifically, the control unit 120 may obtain information about the target C-rate corresponding to the battery profile from the profile obtaining unit 110.

For example, assume that the battery is charged at 0.33 C. In this case, the target C-rate corresponding to the battery profile is 0.33 C. The control unit 120 may receive the battery profile and the information about 0.33 C from the profile obtaining unit 110. Then, the control unit 120 may determine 0.33 C corresponding to the battery profile as the target C-rate.

The control unit 120 may be configured to generate a corrected profile by correcting the battery profile based on an overpotential profile corresponding to the target C-rate.

Specifically, the overpotential profile may be preset to represent an overpotential portion included in the battery profile. More specifically, the overpotential profile may be preset based on a reference battery profile of a reference battery for a reference C-rate and a target battery profile of the reference battery for the target C-rate. Preferably, the target C-rate may be set to be greater than the reference C-rate. That is, the overpotential profile may be preset to represent a difference between the reference battery profile and the target battery profile.

For example, it is assumed that the reference C-rate is 0.05 C and the target C-rate is 0.33 C. When the reference battery is charged (or discharged) at 0.05 C, a reference battery profile may be obtained. Then, when the reference battery is charged (or discharged) at 0.33 C, a target battery profile may be obtained. Then, an overpotential profile corresponding to 0.33 C may be generated according to the difference between the reference battery profile and the target battery profile. In general, when a battery is charged or discharged at a target C-rate greater than the reference C-rate, an overpotential may be included in the measured battery voltage. Therefore, the control unit 120 may generate an overpotential profile by removing the reference battery profile based on the reference C-rate from the target battery profile based on the target C-rate.

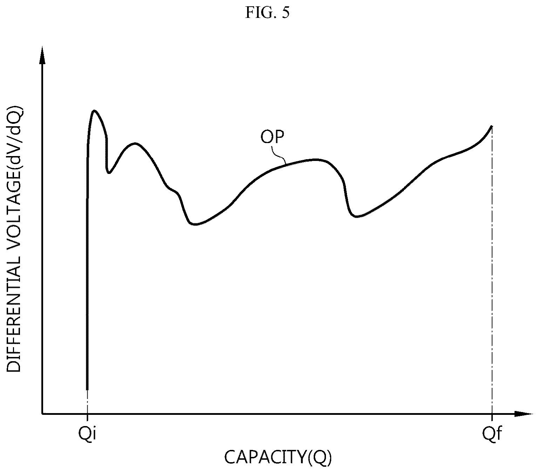

FIG. 5 is a schematic drawing of an overpotential profile OP according to an embodiment of the present disclosure. Specifically, FIG. 5 is the overpotential profile OP corresponding to the first differential profile DP1.

For example, the overpotential profile OP according to the embodiment of FIG. 5 may be expressed as an X-Y graph where the X-axis is set to capacity and the Y-axis is set to differential voltage. That is, if the battery profile obtained by the profile obtaining unit 110 is the first differential profile DP1, the overpotential profile OP may represent the corresponding relationship between the capacity and the differential voltage.

As another example, the overpotential profile corresponding to the second differential profile DP2 may be expressed as an X-Y graph where the X-axis is set to voltage and the Y-axis is set to differential capacity. That is, if the differential profile obtained by the profile obtaining unit 110 is the second differential profile DP2, the overpotential profile may represent the corresponding relationship between the voltage and the differential capacity.

As another example, an overvoltage profile corresponding to the full-cell profile BP may be expressed as an X-Y graph in which the X-axis is set to capacity and the Y-axis is set to voltage. That is, if the battery profile obtained by the profile obtaining unit 110 is a full-cell profile BP, the overvoltage profile may represent the corresponding relationship between capacity and voltage.

In addition, the control unit 120 may be configured to select an overpotential profile OP corresponding to the target C-rate among a plurality of pre-stored overpotential profiles OP.

The overpotential profile OP may be configured to be pre-stored for each of a plurality of C-rates.

Specifically, the overpotential profile OP is provided in plurality, and the C-rates corresponding to each of the plurality of overpotential profiles OP may be different. For example, based on a unit C-rate, an overpotential profile OP corresponding to each C-rate may be pre-stored.

In addition, the overpotential profile OP for a C-rate that has not been experimentally obtained may be obtained and stored through interpolation or extrapolation between similar overpotential profiles OP. Specifically, the control unit 120 may generate overpotential profiles OP for various C-rates in addition to the pre-stored overpotential profile OP through interpolation or extrapolation, and store the generated overpotential profiles OP in the storage unit 130. For example, if an overpotential profile OP corresponding to 1 C and an overpotential profile OP corresponding to 1.2 C are pre-stored, an overpotential profile OP corresponding to 1.1 C may be further obtained based on the difference between the two overpotential profiles OP.

The control unit 120 may be configured to generate a corrected profile by calculating the difference between the battery profile and the overpotential profile OP.

Specifically, the control unit 120 may generate a corrected profile by calculating the difference between the battery profile and the overpotential profile OP in the same way that the overpotential profile OP is generated based on the difference between the reference battery profile and the target battery profile.

For example, if the battery profile is a full-cell profile BP, the control unit 120 may generate a correction corrected by calculating the voltage difference by capacity between the full-cell profile BP and the overvoltage profile OP.

As another example, if the battery profile is the first differential profile DP1, the control unit 120 may generate a corrected profile by calculating the differential voltage difference by capacity between the first differential profile DP1 and the overpotential profile OP.

As still another example, if the battery profile is the second differential profile DP2, the control unit 120 may generate a corrected profile by calculating the differential capacity difference by voltage between the second differential profile DP2 and the overpotential profile OP.

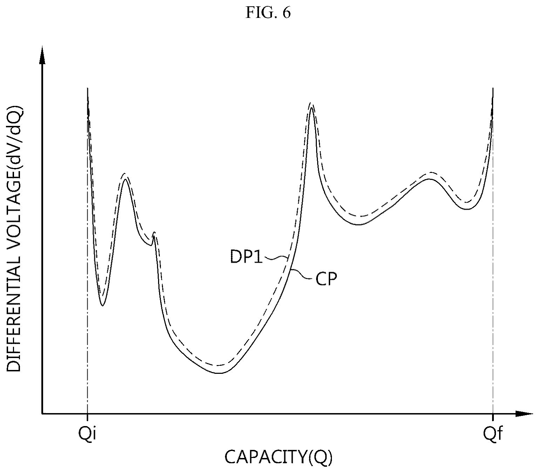

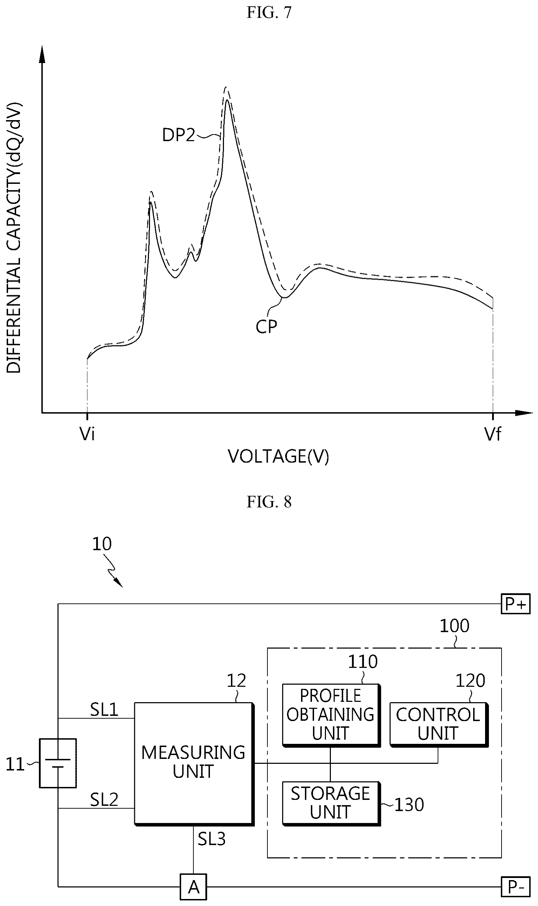

FIG. 6 and FIG. 7 are schematic drawings of a corrected profile according to an embodiment of the present disclosure.

Specifically, FIG. 6 is a diagram illustrating a corrected profile corresponding to the first differential profile DP1. In the embodiments of FIGS. 5 and 6, the corrected profile CP may be generated according to the differential voltage difference by capacity of the first differential profile DP1 and the corresponding overpotential profile OP. That is, the control unit 120 may generate the corrected profile CP from which the overpotential portion included in the first differential profile DP1 is removed by calculating the difference between the first differential profile DP1 and the overpotential profile OP.

Specifically, FIG. 7 is a drawing illustrating a corrected profile corresponding to the second differential profile DP2. In the embodiment of FIG. 7, the corrected profile CP may be generated according to the differential capacity difference by voltage between the second differential profile DP2 and the corresponding overpotential profile (not shown). That is, the control unit 120 may generate a corrected profile from which the overpotential portion included in the second differential profile DP2 is removed by calculating the difference between the second differential profile DP2 and the overpotential profile.

According to an embodiment of the present disclosure, since charging and discharging the battery at a low C-rate (e.g., 0.05 C) is not forced to obtain an accurate profile for the battery, a corrected profile CP from which overpotential is removed may be quickly obtained. In addition, since the corrected profile CP is used for diagnosing the state of the battery, the battery information generating apparatus 100 has an advantage of being able to quickly generate a profile used for diagnosing the battery.

For example, if a low-rate charge/discharge of 0.05 C is forced to obtain the full-cell profile BP as in the conventional method, it may take about 20 hours just to obtain the full-cell profile BP. In addition, additional time may be required in the process of converting the obtained full-cell profile BP into a differential profile DP1, DP2. That is, since a considerable amount of time is required in the process of obtaining the full-cell profile BP according to the conventional method, there is a problem in that the state of the battery cannot be diagnosed quickly.

On the other hand, if the battery is charged and discharged at 0.33 C as in an embodiment of the present disclosure, the full-cell profile BP may be obtained in about 3 hours. That is, according to an embodiment of the present disclosure, the time required to obtain the full-cell profile BP may be drastically reduced compared to the conventional method.

However, the full-cell profile BP obtained according to an embodiment of the present disclosure includes overpotential corresponding to noise. Therefore, the battery information generating apparatus 100 may quickly remove the noise included in the battery profile by calculating the difference between the battery profile and the overpotential profile. Therefore, even if the time required for the process of generating the corrected profile CP is further considered, the battery information generating apparatus 100 has an advantage in that it can generate a profile capable of diagnosing the state of the battery very quickly compared to the conventional method.

Meanwhile, the profile obtaining unit 110 and/or the control unit 120 included in the battery information generating apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and/or the control unit 120. The memory may be inside or outside the profile obtaining unit 110 and/or the control unit 120 and may be connected to the profile obtaining unit 110 and/or the control unit 120 by various well-known means.

In addition, the battery information generating apparatus 100 may further include a storage unit 130. The storage unit 130 may store data necessary for operation and function of each component of the battery information generating apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and/or the control unit 120 are defined.

The storage unit 130 may store the full-cell profile BP, the battery profile DP1, DP2, the overpotential profile OP, and the corrected profile CP.

In one embodiment, the profile obtaining unit 110 may be configured to obtain a full-cell profile BP representing the corresponding relationship between capacity and voltage. The control unit 120 may be configured to correct the full-cell profile BP based on an overvoltage profile OP representing the corresponding relationship between capacity and voltage.

In another embodiment, the profile obtaining unit 110 may be configured to obtain a first differential profile DP1 representing a corresponding relationship between the capacity and the differential voltage. The control unit 120 may be configured to correct the first differential profile DP1 based on the overpotential profile OP representing the corresponding relationship between the capacity and the differential voltage.

In still another embodiment, the profile obtaining unit 110 may be configured to obtain a second differential profile DP2 representing a corresponding relationship between the voltage and the differential capacity. The control unit 120 may be configured to correct the second differential profile DP2 based on the overpotential profile representing the corresponding relationship between the voltage and the differential capacity.

Specifically, since the difference between the battery profile and the overpotential profile OP must be calculated in order to generate the corrected profile CP, the formats of the battery profile and the overpotential profile OP may be the same.

That is, if the battery profile represents a corresponding relationship between the capacity and the voltage, the overpotential profile OP may represent a corresponding relationship between the capacity and the voltage. Also, if the battery profile represents a corresponding relationship between the capacity and the differential voltage, the overpotential profile OP may represent a corresponding relationship between the capacity and the differential voltage. Finally, if the battery profile represents a corresponding relationship between the voltage and the differential capacity, the overpotential profile OP also represents a corresponding relationship between the voltage and the differential capacity.

The control unit 120 may be configured to provide information about the battery by outputting the corrected profile CP to the outside.

Specifically, the control unit 120 may be connected to an external device capable of diagnosing the state of the battery based on the corrected profile CP, and may communicate with the external device via wired and/or wireless communication. The control unit 120 may transmit the corrected profile CP to the external device via wired and/or wireless communication. For example, the external device includes a diagnostic device or a server, and any device capable of diagnosing the state of the battery by analyzing the corrected profile CP may be applied without limitation.

Since the corrected profile CP is a profile representing the current state of the battery, the state of the battery may be diagnosed based on the corrected profile CP.

For example, if the corrected profile CP corresponds to the full-cell profile BP, the corresponding relationship between the voltage and capacity of the battery may be more accurately represented based on the corrected profile CP. Therefore, the condition of the battery may be more accurately diagnosed based on the voltage and capacity of the battery, and various factors based thereon.

As another example, if the corrected profile CP corresponds to the differential profile DP1, DP2, the condition of the battery may be diagnosed based on the behavior of the peak included in the corrected profile CP. Here, the peak means a maximum or minimum point of the corrected profile CP. If the state of the battery is diagnosed according to a differential profile including overpotential, the state of the battery may not be accurately diagnosed due to the influence of the overpotential. However, since the battery information generating apparatus 100 generates a corrected profile CP by removing the overpotential included in the differential profile, the state of the battery may be diagnosed more accurately according to the corrected profile CP. That is, the battery information generating apparatus 100 may drastically reduce the total time required for diagnosing the state of the battery by quickly generating the corrected profile CP used for diagnosing the state of the battery.

The battery information generating apparatus 100 according to the present disclosure may be applied to a battery management system (BMS). That is, the BMS according to the present disclosure may include the battery information generating apparatus 100 described above. In this configuration, at least some of components of the battery information generating apparatus 100 may be implemented by supplementing or adding functions of the components included in a conventional BMS. For example, the profile obtaining unit 110, the control unit 120 and the storage unit 130 of the battery information generating apparatus 100 may be implemented as components of the BMS.

Additionally, the battery information generating apparatus 100 according to the present disclosure may be provided in the battery pack. That is, the battery pack according to the present disclosure may include the above-described battery information generating apparatus 100 and at least one battery cell. Additionally, the battery pack may further include electrical components (relays, fuses, etc.) and a case.

FIG. 8 is a diagram showing a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a battery profile and a differential profile based on the battery information.

As another example, the profile obtaining unit 110 may receive a battery profile from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

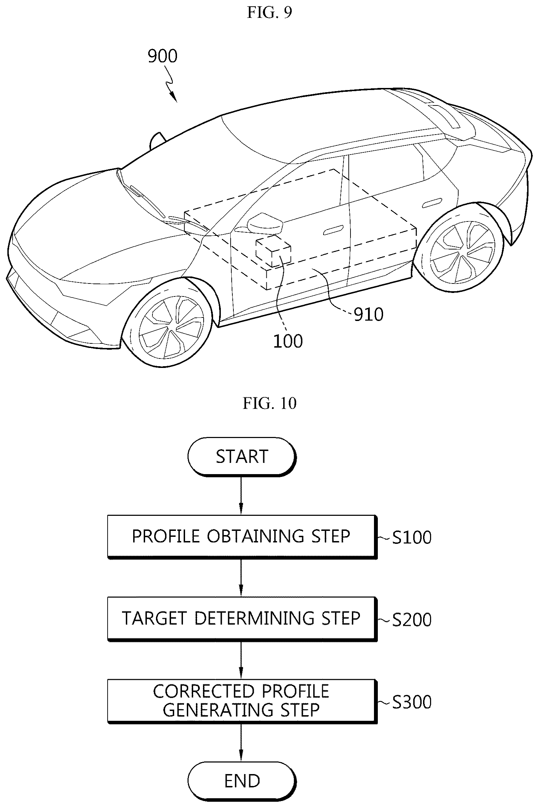

FIG. 9 is a drawing schematically showing a vehicle according to still another embodiment of the present disclosure.

Referring to FIG. 9, the battery pack according to the embodiment of the present disclosure may be included in a vehicle 900, such as an electric vehicle (EV) or a hybrid vehicle (HV). In addition, the battery pack 910 may drive the vehicle 900 by supplying power to a motor through an inverter provided in the vehicle 900. Here, the battery pack 910 may include the battery information generating apparatus 100. That is, the vehicle 900 may include the battery information generating apparatus 100. In this case, the battery information generating apparatus 100 may be an onboard device included in the vehicle 900.

FIG. 10 is a diagram schematically showing a battery information generating method according to still another embodiment of the present disclosure.

Referring to FIG. 10, the battery information generating method may include a profile obtaining step (S100), a target determining step (S200), and a corrected profile generating step (S300).

Preferably, each step of the battery information generating method may be performed by the battery information generating apparatus 100. Hereinafter, for convenience of explanation, content that overlaps with the content described above will be omitted or briefly described.

The profile obtaining step (S100) is a step of obtaining a battery profile based on a voltage and a capacity of a battery, and may be performed by the profile obtaining unit 110.

For example, the profile obtaining unit 110 may obtain at least one of the full-cell profile BP, the first differential profile DP1 and the second differential profile DP2.

The target determining step (S200) is a step of determining a target C-rate corresponding to the battery profile, and may be performed by the control unit 120.

For example, the control unit 120 may receive information about the battery profile and the C-rate from the profile obtaining unit 110. Then, the control unit 120 may determine a C-rate corresponding to the battery profile as a target C-rate.

The corrected profile generating step (S300) is a step of generating a corrected profile CP by correcting the battery profile based on an overpotential profile OP corresponding to the target C-rate, and may be performed by the control unit 120.

In addition, the control unit 120 may be configured to select an overpotential profile OP corresponding to the target C-rate among a plurality of pre-stored overpotential profiles OP. The control unit 120 may be configured to generate a corrected profile CP by calculating a difference between the battery profile and the overpotential profile OP.

For example, if the battery profile is a full-cell profile BP, the control unit 120 may generate a corrected profile CP by calculating the voltage difference by capacity between the full-cell profile BP and the overvoltage profile OP.

As another example, if the battery profile is the first differential profile DP1, the control unit 120 may generate a corrected profile CP by calculating the differential voltage difference by capacity between the first differential profile DP1 and the overpotential profile OP.

As still another example, if the battery profile is the second differential profile DP2, the control unit 120 may generate a corrected profile by calculating the differential capacity difference by voltage between the second differential profile DP2 and the overpotential profile.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: measuring unit
100: battery information generating apparatus
110: profile obtaining unit
120: control unit
130: storage unit
900: vehicle
910: battery pack

## Claims

1. A battery information generating apparatus, comprising:
a profile obtaining unit configured to obtain a battery profile based on a voltage and a capacity of a battery; and
a control unit configured to determine a target C-rate corresponding to the battery profile and generate a corrected profile by correcting the battery profile based on an overpotential profile corresponding to the target C-rate.

2. The battery information generating apparatus according to claim 1,
wherein the control unit is configured to generate the corrected profile by calculating a difference between the battery profile and the overpotential profile.

3. The battery information generating apparatus according to claim 1,
wherein the overpotential profile is configured to be pre-stored for each of a plurality of C-rates, and
wherein the control unit is configured to select an overpotential profile corresponding to the target C-rate from among a plurality of overpotential profiles pre-stored.

4. The battery information generating apparatus according to claim 1,
wherein the overpotential profile is preset based on a reference battery profile of a reference battery for a reference C-rate and a target battery profile of the reference battery for the target C-rate.

5. The battery information generating apparatus according to claim 4,
wherein the overpotential profile is preset to represent a difference between the reference battery profile and the target battery profile.

6. The battery information generating apparatus according to claim 4,
wherein the target C-rate is set to be greater than the reference C-rate.

7. The battery information generating apparatus according to claim 1,
wherein the control unit is configured to provide information about the battery by outputting the corrected profile to the outside.

8. A battery pack, comprising the battery information generating apparatus according to any one of claims 1 to 7.

9. A vehicle, comprising the battery information generating apparatus according to any one of claims 1 to 7.

10. A battery information generating method, comprising:
a profile obtaining step of obtaining a battery profile based on a voltage and a capacity of a battery;
a target determining step of determining a target C-rate corresponding to the battery profile; and
a corrected profile generating step of generating a corrected profile by correcting the battery profile based on an overpotential profile corresponding to the target C-rate.
